# EUROPEAN PATENT SPECIFICATION

(11) **EP 1 399 600 B1**
(45) Date of publication and mention of the grant of the patent: **17.01.2007**
(21) Application number: 01948248.8
(22) Date of filing: 28.05.2001
(51) Int. Cl.: C22C 13/00

(54) **COMPOSITIONS, METHODS AND DEVICES FOR HIGH TEMPERATURE LEAD-FREE SOLDER**
ZUSAMMENSETZUNGEN; VERFAHREN UND VORRICHTUNGEN FÜR BLEIFREIES HOCHTEMPERATURLÖTMITTEL
COMPOSITIONS, PROCEDES ET DISPOSITIFS DESTINES A UNE BRASURE SANS PLOMB A TEMPERATURE ELEVEE

(43) Date of publication of application: 24.03.2004
(60) Divisional application: 06000798.6
(73) Proprietor: Honeywell International Inc., Morristown, New Jersey 07962 (US)
(72) Inventor: LALENA, John, Morristown, NJ 07962 (US); DEAN, Nancy, Morristown, NJ 07962 (US); WEISER, Martin, Morristown, NJ 07962 (US)
(74) Representative: Hucker, Charlotte Jane
(86) International application number: PCT/US2001/017491
(87) International publication number: WO 2002/097145

(56) References cited:
- JP-A- 11 050 296
- JP-A- 11 320 177
- US-B1- 6 228 322
- PATENT ABSTRACTS OF JAPAN vol. 1999, no. 05, 31 May 1999 (1999-05-31) & JP 11 050296 A (TOYOTA MOTOR CORP; TOYOTA CENTRAL RES & DEV LAB INC), 23 February 1999 (1999-02-23)
- HUMPSTON G ET AL: "SOLDER SPREAD: A CRITERION FOR EVALUATION OF SOLDERING" GOLD BULLETIN AND GOLD PATENT DIGEST, WORLD GOLD COUNCIL, GENEVA, CH, vol. 23, no. 3, 1990, pages 83-96, XP001070073 ISSN: 1016-5339
- PATENT ABSTRACTS OF JAPAN vol. 2000, no. 02, 29 February 2000 (2000-02-29) & JP 11 320177 A (MURATA MFG CO LTD), 24 November 1999 (1999-11-24)
- DATABASE HCA [Online] OKAJIMA ET AL.: 'Densities of liquid bismuth-silver and bismuth-cadmium alloys', XP002946436 Database accession no. 98:222260 & TRANS. JPN. INST. MET. vol. 24, no. 4, 1983, pages 216 - 222

## Description

### Field of The Invention

The field of the invention is lead-free solders.

### Background of The Invention

Numerous known die attach methods employ a high-lead solder to attach the semiconductor die within an integrated circuit to a leadframe for mechanical connection and to provide thermal and electrical conductivity between the die and leadframe. Although most high-lead solders are relatively inexpensive and exhibit various desirable physico-chemical properties, the use of lead in die attach and other solders has come under increased scrutiny from an environmental and occupational health perspective. Consequently, various approaches have been undertaken to replace lead-containing solders with lead-free die attach compositions.

For example, in one approach polymeric adhesives (*e.g*., epoxy resins or cyanate ester resins) are employed to attach a die to a substrate as described in U.S. Pat. Nos. 5,150,195, 5,195,299, 5,250,600, 5,399,907, and 5,386,000. Polymeric adhesives typically cure within a relatively short time at temperatures generally below 200°C, and may even retain structural flexibility after curing to allow die attach of integrated circuits onto flexible substrates as shown in U.S. Pat. No. 5,612,403. However, many polymeric adhesives tend to produce resin bleed, potentially leading to undesirable reduction of electrical contact of the die with the substrate, or even partial or total detachment of the die.

To circumvent at least some of the problems with resin bleed, silicone-containing die attach adhesives may be employed as described in U.S. Pat. No. 5,982,041 to *Mitani et al*. While such adhesives tend to improve the bonding of the wire as well as that between the resin sealant and the semiconductor chip, substrate; package, and/or lead frame, the curing process for at least some of such adhesives requires a source of high-energy radiation, which may add significant cost to the die attach process.

Alternatively, a glass paste comprising a high-lead borosilicate glass may be employed as described in U.S. Pat. No. 4,459,166 to *Dietz* et al., thereby generally avoiding a high-energy curing step. However, many glass pastes comprising a high-lead borosilicate glass require temperatures of 425°C and higher to permanently bond the die to the substrate. Moreover, glass pastes frequently tend to crystallize during heating and cooling, thereby reducing the adhesive qualities of the bonding layer.

In yet another approach, various high melting solders are employed to attach a die to a substrate or leadframe. Soldering a die to a substrate has various advantages, including relatively simple processing, solvent-free application, and in some instances relatively low cost. There are various high melting solders known in the art. However, all or almost all of them have one or more disadvantages. For example, most gold eutectic alloys (*e.g*., Au-20%Sn, Au-3%Si, Au-12%Ge, and Au-25%Sb) are relatively costly and frequently suffer from less-than-ideal mechanical properties. Alternatively, Alloy J (Ag-10%Sb-65%Sn, see e.g., U.S. Pat. No. 4,170,472 to *Olsen et al*.) may be employed in various high melting solder applications. However, Alloy J has a solidus of 228°C and also suffers form relatively poor mechanical performance. A solder composition of 97% Bi - 3% Ag is known from Hangston et al "Solder spread: A Criterion for Evaluation of Soldering "Gold Bulletin and Gold Patent Digest, World Gold Council, Geneva, CH, volume 23, no.3, 1990, pages 83-96. Tests on this solder composition reveal it to have poor mechanical properties as a result of its poor wetting characteristics.

Although various methods and compositions for solders and die attach compositions are known in the art, all or almost all of them suffer from one or more disadvantages. Thus, there is still a need to provide improved compositions and methods for solders, and particularly for lead-free solders.

### Summary of the Invention

The present invention is directed to methods, compositions, and devices as provided and defined in claims 1 or 13 that include a

In one aspect of the inventive subject matter, the silver in the alloy is present in an amount of 2wt% to 7wt% and the bismuth in an amount of 98wt% to 93wt%, or the silver in the alloy is present in an amount of 7wt% to 18wt% and the bismuth in an amount of 93wt% to 82wt%, or the silver in the alloy is present in an amount of 5wt% to 9wt% and the bismuth in an amount of 95wt% to 91wt%.

In another aspect of the inventive subject matter, contemplated solders have a thermal conductivity of at least 9 W/m K, and exhibit a wetting force to wet Ag of approximately 0.2mN on a wetting balance after 1 second. Contemplated compositions may be formed into various shapes, including wires, ribbons, preforms, spheres, or ingots.

In a further aspect of the inventive subject matter, an electronic device comprises a semiconductor die that is coupled to a surface via contemplated compositions, wherein particularly contemplated semiconductor dies include silicon, germanium, and gallium arsenide dies. It is further contemplated that at least one of a portion of the die or a portion of the surface of such devices may be metallized with silver. In particularly preferred aspects, the surface comprises a silver-metallized leadframe. In further aspects, contemplated solders are utilized in an area array electronic package in form of a plurality of bumps on a semiconductor die to serve as electrical interconnects between the die and either a package substrate (generally known as flip chip) or a printed wiring board (generally known as chip on board). Alternatively, contemplated solders my be employed in the form of a plurality of solder balls to connect a package to a substrate (generally known as ball grid array with many variations on the theme) or to connect the die to either a substrate or printed wiring board.

Various objects, features, aspects and advantages of the present invention will become more apparent from the following detailed description of preferred embodiments of the invention along with the accompanying drawing.

### Brief Description of the Drawing

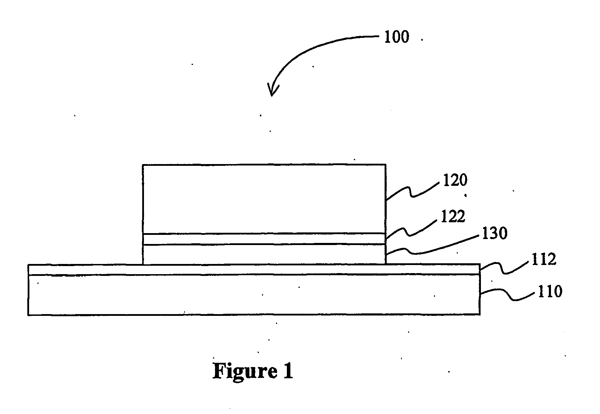

Figure 1 is a schematic vertical cross section of an exemplary electronic device.

### Detailed Description

The inventors have discovered that, among other desirable properties, contemplated compositions may advantageously be employed as near drop-in replacement for high-lead-containing solders in various die attach applications. In particular, contemplated compositions are lead-free alloys having a solidus of no lower than 262.5°C and a liquidus of no higher than 400°C.

The inventive compositions are alloys that may be used as solder and that consist of silver in an amount of 2wt% to 18wt%, a bismuth in an amount of 98wt% to 82wt% and one or more chemical elements in an amount of between 10 ppm and 1000 ppm of the total weight of Ag and Bi, and having an oxygen affinity that is higher than the oxygen affinity of the Ag and Bi portion of the alloy. In a preferred method of preparing contemplated compositions, a charge of appropriately weighed quantities (*supra*) of the pure metals, is heated under vacuum or an inert atmosphere (*e*.*g*., nitrogen or helium) to between 960°C-1000°C in a refractory or heat resistant vessel (*e*.*g*., a graphite crucible) until a liquid solution forms. The charge is stirred and allowed to remain at that temperature for an amount of time sufficient to ensure complete mixing and melting of both metals. The molten mixture, or melt, is then quickly poured into a mold, allowed to solidify by cooling to ambient temperature, and fabricated into wire by conventional extrusion techniques, which includes heating the billet to approximately 190°C, or into ribbon by a process in which a rectangular slab is first annealed at temperatures between 225-250°C and then hot-rolled at the same temperature. Alternatively, a ribbon may be extruded that can subsequently be rolled to thinner dimensions. The melting step may also be carried out under air so long as the slag that forms is removed before pouring the mixture into the mold.

In alternative aspects of the inventive subject matter, and especially where higher liquidus temperatures are desired, contemplated compositions may include Ag in the alloy in an amount of 7wt% to 18wt% and Bi in an amount of 93wt% to 82wt%. On the other hand, where relatively lower liquidus temperatures are desired, contemplated compositions may include Ag in the alloy in an amount of 2wt% to 7wt% and Bi in an amount of 98wt% to 93wt%. However, it is generally contemplated that most die attach applications may employ a composition in which Ag is present in the alloy in an amount of 5wt% to 10wt% and Bi in an amount of 95wt% to 90wt%.

It should be particularly appreciated that contemplated compositions may be employed as lead-free solders that are also completely devoid of Sn, which is a common predominant component in known lead-free solder.

For example, compositions as defined in claim 1 include one or more chemical elements having an oxygen affinity that is higher than the oxygen affinity of the alloy (without the chemical element). Especially contemplated chemical elements include Al, Ba, Ca, Ce, Cs, Hf, Li, Mg, Nd, P, Sc, Sr, Ti, Y, and Zr, and such chemical elements are present in the alloy at a concentration of between about 10 ppm and approximately 1000ppm. While not wishing to be bound to a particular theory or mechanism, it is contemplated that elements having a higher oxygen affinity than the alloy reduce metal oxides that are known to increase the surface tension of a melting or molten solder. Therefore, it is contemplated that a decrease in the amount of metal oxides during soldering will generally reduce the surface tension of the molten solder, and thereby significantly increase the wetting ability of the solder.

It should further be appreciated that addition of chemical elements or metals to improve one or more physico-chemical or thermo-mechanical properties can be done in any order so long as all components in the alloy are substantially completely (*i*.*e*., at least 95% of each component) molten, and it is contemplated that the order of addition is not limiting to the inventive subject matter. Similarly, it should be appreciated that while it is preferred that silver and bismuth are combined prior to the melting step, it is also contemplated that the silver and bismuth may be melted separately, and that the molten silver and molten bismuth are subsequently combined. A further prolonged heating step to a temperature above the melting point of silver may be added to ensure substantially complete melting and mixing of the components.

With respect to thermal conductivity of contemplated alloys, it is contemplated that compositions according to the inventive subject matter have a conductivity of no less than 5 W/mK, more preferably of no less than 9 W/mK, and most preferably of no less than 15W/mK. It is further contemplated that suitable compositions include a solder having a wetting force to wet Ag of more than 0.1 mN, more preferably more than 0.2 mN, and most preferably more than 0.3 mN on a wetting balance after 1 second. It is still further contemplated that a particular shape of contemplated compositions is not critical to the inventive subject matter. However, it is preferred that contemplated compositions are formed into a wire shape, ribbon shape, or a spherical shape (solder bump).

Among various other uses, contemplated compounds (*e.g*., in wire form) may be used to bond a first material to a second material. For example, contemplated compositions (and materials comprising contemplated compositions) may be utilized in an electronic device to bond a semiconductor die (*e*.*g*., silicon, germanium, or gallium arsenide die) to a leadframe as depicted in **Figure 1.** Here, the electronic device 100 comprises a leadframe 110 that is metallized with a silver layer 112. A second silver layer 122 is deposited on the semiconductor die 120 (*e*.*g*., by backside silver metallization). The die and the leadframe are coupled to each other via their respective silver layers by contemplated composition 130 (here, *e*.*g*., a solder comprising an alloy that includes Ag in an amount of 2wt% to 18wt% and Bi in an amount of 98wt% to 82wt%, wherein the alloy has a solidus of no lower than 262.5°C and a liquidus of no higher than 400°C). In an optimum die attach process, contemplated compositions are heated to about 40°C above the liquidus of the particular alloy for 15 seconds and preferably no higher than 430°C for no more than 30 seconds. The soldering can be carried out under a reducing atmosphere (*e*.*g*., hydrogen or forming gas).

In further alternative aspects, it is contemplated that the compounds according to the inventive subject matter may be employed in numerous soldering processes other than die attach applications. In fact, contemplated compositions may be particularly useful in all, or almost all step solder applications in which a subsequent soldering step is performed at a temperature below the melting temperature of contemplated compositions. Furthermore, contemplated compositions may also be employed as a solder in applications where high-lead solders need to be replaced with lead-free solders, and solidus temperatures of greater than 262.5°C are desirable. Particularly preferred alternative uses include use of contemplated solders in joining components of a heat exchanger as a non-melting standoff sphere or electrical/thermal interconnection.

### Examples

Due to the differences in the coefficient of thermal expansion of various materials, solder joints will frequently experience shear loading. Therefore, it is especially desirable that alloys coupling such materials have a low shear modulus and, hence, good thermomechanical fatigue resistance. For example, in die attach applications low shear modulus and good thermomechanical fatigue help prevent cracking of a die, especially where relatively large dies are coupled to a solid support.

Based on the known elastic moduli of the pure metals, the fact that Ag and Bi exhibit partial solid miscibility, and the fact that the Ag-Bi system contains no intermetallic or intermediate phases, it is contemplated that the room temperature shear modulus of contemplated Ag-Bi alloys will be in the range of 13-16 GPa (assuming room temperature shear modulus to be an additive property - *i*.*e*., following the rule-of mixtures). Room temperature shear moduli in the range of 13-16 GPa of contemplated alloys are especially favorable in comparison to 25 GPa for both Au-25%Sb and Au-20%Sn alloys (calculated by the same method and making the same assumption), and 21GPa for Alloy J (Ag-10%Sb-65%Sn), with 22.3 GPa being a measured value for Alloy J.

Test assemblies constructed of a silicon die bonded to a leadframe with Ag-89%Bi alloy have shown no visible signs of failure after 1500 thermal aging cycles, which is in further support of the calculated and observed low shear modulus of contemplated Ag-Bi alloys.

In the test assemblies and various other die attach applications the solder is generally made as either a thin sheet that is placed between the die and the substrate to which it is to be soldered. Subsequent heating will melt the solder and form the joint. Alternatively the substrate can be heated followed by placing the solder on the heated substrate in thin sheet, wire, melted solder, or other form to create a droplet of solder where the semiconductor die is placed to form the joint.

For area array packaging contemplated solders can be placed as a sphere, small preform, paste made from solder powder, or other forms to create the plurality of solder joints generally used for this application. Alternatively, contemplated solders may be used in processes comprising plating from a plating bath, evaporation from solid or liquid form, printing from a nozzle like an ink jet printer, or sputtering to create an array of solder bumps used to create the joints.

In a preferred method, spheres are placed on pads on a package using either a flux or a solder paste (solder powder in a liquid vehicle) to hold the spheres in place until they are heated to bond to the package. The temperature may either be such that the solder spheres melt or the temperature may be below the melting point of the solder when a solder paste of a lower melting composition is used. The package with the attached solder balls is then aligned with an area array on the substrate using either a flux or solder paste and heated to form the joint.

A preferred method for attaching a semiconductor die to a package or printed wiring board includes creating solder bumps by printing a solder paste through a mask, evaporating the solder through a mask, or plating the solder on to an array of conductive pads. The bumps or columns created by such techniques can have either a homogeneous composition so that the entire bump or column melts when heated to form the joint or can be inhomogeneous in the direction perpendicular to the semiconductor die surface so that only a portion of the bump or column melts.

## Claims

1. A composition suitable for a solder comprising
an alloy that consists of Ag in an amount of 2wt% to 18wt%, Bi in an amount of 98wt% to 82wt%, both based on the total weight of Ag and Bi, and
one or more chemical elements in an amount of between 10 ppm and 1000ppm of the total weight of Ag and Bi, said chemical element having an oxygen affinity that is higher than the oxygen affinity of the Ag and Bi portion of the alloy, wherein the alloy has a solidus of no lower than 262.5°C and a liquidus of no higher than 400°C.

2. The composition of claim 1, wherein the Ag in the alloy is present in an amount of 2wt% to 7wt% and Bi in an amount of 98wt% to 93wt%, based on the total weight of Ag and Bi.

3. The composition of claim 1, wherein the Ag in the alloy is present in an amount of 7wt% to 18wt% and Bi in an amount of 93wt% to 82wt%, based on the total weight of Ag and Bi.

4. The composition of claim 1, wherein the Ag in the alloy is present in an amount of 5wt% to 10wt% and Bi in an amount of 95wt% to 90wt%, based on the total weight of Ag and Bi.

5. The composition of any one of claims 1 to 4, wherein the solder has a thermal conductivity of no less than 9 W/mK.

6. The composition of any one of claims 1 to 4, wherein the solder has a wetting force to wet Ag of approximately 0.2mN on a wetting balance after 1 second.

7. The composition of any one of claims 1 to 6, wherein the chemical element is selected from the group consisting of Al, Ba, Ca, Ce, Cs, Hf, Li, Mg, Nd, P, Sc, Sr, Ti, Y, and Zr.

8. The composition of any one of claims 1 to 7, wherein the alloy is formed into at least one of a wire, a ribbon, a preform, an anode, a sphere, a paste, and an evaporation slug

9. An electronic device comprising a semiconductor die coupled to a surface via a material comprising the composition according to any one of claims 1 to 8.

10. The electronic device of claim 9, wherein at least a portion of the semiconductor die is metallized with Ag.

11. The electronic device of claim 9, wherein at least a portion of the surface is metallized with Ag

12. The electronic device of claim 9, wherein the surface comprises a silver-metallized leadframe.

13. A method of manufacturing a solder composition, comprising
providing Ag, Bi and one or more chemical elements, wherein Ag is present in an amount of 2wt% to 18wt% and Bi in an amount of 98wt% to 82wt% of the total weight of Ag and Bi, and said one or more chemical elements are provided in an amount between 10ppm and 1000ppm of the total weight of Ag and Bi
melting the Ag, Bi and one or more chemical elements to a temperature of at least 960°C to form an alloy having a solidus of no lower than 262 5°C and a liquidus of no higher than 400°C, wherein said one or more chemical elements have an oxygen affinity that is higher than the oxygen affinity of the Ag and Bi portion of the alloy.

14. The method of claim 13, wherein the step of melting the Ag and Bi is preceded by a step of combining the Ag and Bi.

15. The method of claim 13, wherein the Ag is present in an amount of 2wt% to 7wt% and Bi in an amount of 98wt% to 93wt%, based on the total weight of Ag and Bi.

16. The method of claim 13, wherein the Ag is present in an amount of 7wt% to 18wt% and Bi in an amount of 93wt% to 82wt%, based on the total weight of Ag and Bi.

17. The method of claim 13, wherein the Ag is present in an amount of 5wt% to 10wt% and Bi in an amount of 95wt% to 90wt%, based on the total weight of Ag and Bi.

18. The method as claimed in any one of claims 13 to 17, wherein the chemical element is selected from the group consisting of Al, Ba, Ca, Ce, Cs, Hf, Li, Mg, Nd, P, Sc, Sr, Ti, Y, and Zr.

## Patentansprüche

1. Zusammensetzung, die für ein Lötmittel geeignet ist, umfassend:
eine Legierung, die in einer Menge von 2 Gew.-% bis 18 Gew.-% aus Ag und in einer Menge von 98 Gew.-% bis 82 Gew.-% aus Bi besteht, wobei beide auf dem Gesamtgewicht von Ag und Bi basieren, und
ein oder mehrere chemische Elemente in einer Menge zwischen 10 ppm und 1000 ppm des Gesamtgewichts von Ag und Bi, wobei das chemische Element eine Sauerstoffaffinität aufweist, die höher ist als die Sauerstoffaffinität des Ag- und Bi-Anteils der Legierung, wobei die Legierung einen Solidus von nicht weniger als 262,5 ºC und einen Liquidus von nicht mehr als 400 ºC aufweist.

2. Zusammensetzung nach Anspruch 1, wobei basierend auf dem Gesamtgewicht von Ag und Bi das Ag in der Legierung in einer Menge von 2 Gew.-% bis 7 Gew.-% und Bi in einer Menge von 98 Gew.-% bis 93 Gew.-% vorliegt.

3. Zusammensetzung nach Anspruch 1, wobei basierend auf dem Gesamtgewicht von Ag und Bi das Ag in der Legierung in einer Menge von 7 Gew.-% bis 18 Gew.-% und Bi in einer Menge von 93 Gew.-% bis 82 Gew.-% vorliegt.

4. Zusammensetzung nach Anspruch 1, wobei basierend auf dem Gesamtgewicht von Ag und Bi das Ag in der Legierung in einer Menge von 5 Gew.-% bis 10 Gew.-% und Bi in einer Menge von 95 Gew.-% bis 90 Gew.-% vorliegt.

5. Zusammensetzung nach einem der Ansprüche 1 bis 4, wobei das Lötmittel eine Wärmeleitfähigkeit von nicht weniger als 9 W/mK aufweist.

6. Zusammensetzung nach einem der Ansprüche 1 bis 4, wobei das Lötmittel nach 1 Sekunde auf einer Benetzungsbilanz eine Benetzungskraft bezüglich feuchtem Ag von etwa 0,2 mN aufweist.

7. Zusammensetzung nach einem der Ansprüche 1 bis 6, wobei das chemische Element ausgewählt ist aus der Gruppe, bestehend aus Al, Ba, Ca, Ce, Cs, Hf, Li, Mg, Nd, P, Sc, Sr, Ti, Y und Zr.

8. Zusammensetzung nach einem der Ansprüche 1 bis 7, wobei die Legierung in mindestens einen von einem Draht, einem Band, einer Vorform, einer Anode, einer Kugel, einer Paste und einem Verdampfungsrohling geformt ist.

9. Elektronische Vorrichtung, umfassend ein Halbleiterplättchen, das mit einer Fläche durch ein Material verbunden ist, das die Zusammensetzung nach einem der Ansprüche 1 bis 8 umfasst.

10. Elektronische Vorrichtung nach Anspruch 9, wobei mindestens ein Abschnitt des Halbleiterplättchens mit Ag metallisiert ist.

11. Elektronische Vorrichtung nach Anspruch 9, wobei mindestens ein Abschnitt der Fläche mit Ag metallisiert ist.

12. Elektronische Vorrichtung nach Anspruch 9, wobei die Fläche eine mit Silber metallisierte Leiterplatine umfasst.

13. Verfahren zum Herstellen einer Lötmittelzusammensetzung, umfassend:
Bereitstellen von Ag, Bi und einem oder mehreren chemischen Elementen, wobei Ag in einer Menge von 2 Gew.-% bis 18 Gew.-% und Bi in einer Menge von 98 Gew.-% bis 82 Gew.-% des Gesamtgewichts von Ag und Bi vorliegt und das eine oder die mehreren chemischen Elemente in einer Menge zwischen 10 ppm und 1000 ppm des Gesamtgewichts von Ag und Bi vorliegen.
Schmelzen von Ag, Bi und eines oder mehrerer chemischer Elemente auf eine Temperatur von mindestens 960 ºC, um eine Legierung zu bilden, die einen Solidus von nicht weniger als 262,5 ºC und einen Liquidus von nicht mehr als 400 ºC aufweist, wobei das eine oder die mehreren chemischen Elemente eine Sauerstoffaffinität aufweisen, die höher ist als die Sauerstoffaffinität des Ag- und Bi-Anteils der Legierung.

14. Verfahren nach Anspruch 13, wobei dem Schritt des Schmelzens von Ag und Bi ein Schritt des Kombinierens von Ag und Bi vorausgeht.

15. Verfahren nach Anspruch 13, wobei basierend auf dem Gesamtgewicht von Ag und Bi das Ag in einer Menge von 2 Gew.-% bis 7 Gew.-% und Bi in einer Menge von 98 Gew.-% bis 93 Gew.-% vorliegt.

16. Verfahren nach Anspruch 13, wobei basierend auf dem Gesamtgewicht von Ag und Bi das Ag in einer Menge von 7 Gew.-% bis 18 Gew.-% und Bi in einer Menge von 93 Gew.-% bis 82 Gew.-% vorliegt.

17. Verfahren nach Anspruch 13, wobei basierend auf dem Gesamtgewicht von Ag und Bi das Ag in einer Menge von 5 Gew.-% bis 10 Gew.-% und Bi in einer Menge von 95 Gew.-% bis 90 Gew.-% vorliegt.

18. Verfahren nach einem der Ansprüche 13 bis 17, wobei das chemische Element ausgewählt ist aus der Gruppe, bestehend aus A1, Ba, Ca, Ce, Cs, Hf, Li, Mg, Nd, P, Sc, Sr, Ti, Y und Zr.

## Revendications

1. Composition appropriée pour une brasure comprenant un alliage qui est constitué de Ag dans une quantité de 2 % en poids à 18 % en poids, Bi dans une quantité de 98 % en poids à 82 % en poids, tous deux rapportés au poids total de Ag et Bi, et un ou plusieurs éléments chimiques dans une quantité entre 10 ppm et 1000 ppm du poids total de Ag et Bi, ledit élément chimique possédant une affinité pour l'oxygène qui est supérieure à l'affinité pour l'oxygène de la partie Ag et Bi de l'alliage, dans laquelle l'alliage présente un solidus non inférieur à 262,5°C et un liquidus non supérieur à 400°C.

2. Composition selon la revendication 1, dans laquelle Ag dans l'alliage est présent dans une quantité de 2 % en poids à 7 % en poids et Bi dans une quantité de 98 % en poids à 93 % en poids, rapporté au poids total de Ag et Bi.

3. Composition selon la revendication 1, dans laquelle Ag dans l'alliage est présent dans une quantité de 7 % en poids à 18 % en poids et Bi dans une quantité de 93 % en poids à 82 % en poids, rapporté au poids total de Ag et Bi.

4. Composition selon la revendication 1, dans laquelle Ag dans l'alliage est présent dans une quantité de 5 % en poids à 10 % en poids et Bi dans une quantité de 95 % en poids à 90 % en poids, rapporté au poids total de Ag et Bi.

5. Composition selon l'une quelconque des revendications 1 à 4, dans laquelle la brasure possède une conductivité thermique de pas moins de 9 W/mK.

6. Composition selon l'une quelconque des revendications 1 à 4, dans laquelle la brasure possède un pouvoir mouillant pour mouiller Ag d'environ 0,2 mN sur une balance de mouillage après 1 seconde.

7. Composition selon l'une quelconque des revendications 1 à 6, dans laquelle l'élément chimique est choisi dans le groupe constitué par Al, Ba, Ca, Ce, Cs, Hf, Li, Mg, Nd, P, Sc, Sr, Ti, Y et Zr.

8. Composition selon l'une quelconque des revendications 1 à 7, dans laquelle l'alliage est formé en l'un au moins d'un fil, un ruban, une préforme, une anode, une sphère, une pâte et une perle d'évaporation.

9. Dispositif électronique comprenant une puce semiconductrice couplée à une surface par l'intermédiaire d'un matériau comprenant la composition selon l'une quelconque des revendications 1 à 8.

10. Dispositif électronique selon la revendication 9, dans lequel au moins une partie de la puce semiconductrice est métallisée avec Ag.

11. Dispositif électronique selon la revendication 9, dans lequel au moins une partie de la surface est métallisée avec Ag.

12. Dispositif électronique selon la revendication 9, dans lequel la surface comprend une grille de connexion métallisée à l'argent.

13. Procédé de fabrication d'une composition de brasure, comprenant
la fourniture de Ag, Bi et un ou plusieurs éléments chimiques, Ag étant présent dans une quantité de 2 % en poids à 18 % en poids et Bi dans une quantité de 98 % en poids à 82 % en poids, rapporté au poids total de Ag et Bi, et lesdits un ou plusieurs éléments chimiques étant fournis dans une quantité entre 10 ppm et 1000 ppm du poids total de Ag et Bi,
la fusion de Ag, Bi et un ou plusieurs éléments chimiques à une température d'au moins 960°C pour former un alliage présentant un solidus non inférieur à 262,5°C et un liquidus non supérieur à 400°C, dans lequel lesdits un ou plusieurs éléments chimiques possèdent une affinité pour l'oxygène qui est supérieure à l'affinité pour l'oxygène de la partie Ag et Bi de l'alliage.

14. Procédé selon la revendication 13, dans lequel l'étape de fusion de Ag et Bi est précédée d'une étape de combinaison de Ag et Bi.

15. Procédé selon la revendication 13, dans lequel Ag est présent dans une quantité de 2 % en poids à 7 % en poids et Bi dans une quantité de 98 % en poids à 93 % en poids, rapporté au poids total de Ag et Bi.

16. Procédé selon la revendication 13, dans lequel Ag est présent dans une quantité de 7 % en poids à 18 % en poids et Bi dans une quantité de 93 % en poids à 82 % en poids, rapporté au poids total de Ag et Bi.

17. Procédé selon la revendication 13, dans lequel Ag est présent dans une quantité de 5 % en poids à 10 % en poids et Bi dans une quantité de 95 % en poids à 90 % en poids, rapporté au poids total de Ag et Bi.

18. Procédé selon l'une quelconque des revendications 13 à 17, dans lequel l'élément chimique est choisi dans le groupe constitué par Al, Ba, Ca, Ce, Cs, Hf, Li, Mg, Nd, P, Sc, Sr, Ti, Y et Zr.
